# EUROPÄISCHE PATENTSCHRIFT

(11) **EP 1 190 484 B1**
(45) Veröffentlichungstag und Bekanntmachung des Hinweises auf die Patenterteilung: **28.07.2004**
(21) Anmeldenummer: 00951199.9
(22) Anmeldetag: 30.05.2000
(51) Int. Cl.: H03H 9/145

(54) **WANDLER FÜR AKUSTISCHE OBERFLÄCHENWELLEN**
CONVERTER FOR SURFACE ACOUSTIC WAVES
TRANSDUCTEUR POUR ONDES DE SURFACE

(30) Priorität: 03.06.1999 DE 19925800
(43) Veröffentlichungstag der Anmeldung: 27.03.2002
(73) Patentinhaber: Tele Filter Zweigniederlassung der Dover Germany GmbH, 14513 Teltow (DE)
(72) Erfinder: MARTIN, Günter, D-01307 Dresden (DE)
(74) Vertreter: Rauschenbach, Dieter, Dipl.-Ing. (FH)
(86) Internationale Anmeldenummer: PCT/DE2000/001807
(87) Internationale Veröffentlichungsnummer: WO 2000/076064

(56) Entgegenhaltungen:
- DE-A- 19 724 259
- FR-A- 2 398 411
- US-A- 4 250 474

## Beschreibung

### Technisches Gebiet

Die Erfindung bezieht sich auf das Gebiet Elektrotechnik/Elektronik. Objekte, bei denen die Anwendung möglich und zweckmäßig ist, sind Bauelemente auf der Basis akustischer Oberflächenwellen, wie beispielsweise breitbandige Bandpassfilter und Verzögerungsleitungen.

### Stand der Technik

Es sind Wandler für akustische Oberflächenwellen bekannt, die aus auf einem piezoelektrischen Substrat angeordneten Zinkengruppen, die jeweils aus mindestens zwei Zinken bestehen, zusammengesetzt sind und bei dem wenigstens einige Zinkengruppen so aufgebaut sind, dass sie sich von den übrigen Zinkengruppen hinsichtlich der von ihnen angeregten Wellenamplitude unterscheiden.

Bei einer speziellen Ausführung (WO 97/10646) [1] sind interdigitale Wandler mit sich verjüngender Struktur aus Zinkengruppen zusammengesetzt, die aus drei Zinken bestehen. Zwei dieser Zinken bilden ein reflexionsloses Zinkenpaar, während die jeweils dritte Zinke eine Reflektorzinke ist. Typischerweise beträgt der Abstand zwischen den Mittellinien der Reflektorzinke und der dieser Reflektorzinke benachbarten Zinke des Zinkenpaares 3p_{zg}/8. p_{zg} ist dabei die Länge einer Zinkengruppe längs einer Geraden, die parallel zu den Sammelelektroden in vorgegebenem Abstand von einer dieser Sammelelektroden verläuft. Infolgedessen hat jede Zinkengruppe eine hinsichtlich der erzeugten Wellenamplitude bevorzugte Richtung. Deshalb ist eine Wandlerstruktur dieser Art ein Einphasen-Unidirektionalwandler (Single Phase Unidirectional Transducer, abgekürzt als SPUDT). Wenn die Breite der Reflektorzinke p_{zg}/4 bzw. 3p_{zg}/8 beträgt, so werden die Zinkengruppen als EWC- bzw. DART-Zellen bezeichnet. Solange Einphasen-Unidirektionalwandler nicht als sich verjüngende Strukturen ausgelegt sind, sind sie für Filter mit niedriger Einfügedämpfung bis zu ca. 1% Bandbreite geeignet. Werden Einphasen-Unidirektionalwandler jedoch mit dem Prinzip sich verjungender Strukturen kombiniert, was in [1] der Fall ist, so sind Filter mit niedriger Einfügedämpfung sogar bis mindestens 50% Bandbreite realisierbar.

Um das Übertragungsverhalten der beschriebenen Filter in gewünschter Weise einstellen zu können, ist eine Wichtung der von den einzelnen Zinkengruppen erzeugten Wellenamplituden erforderlich. Die Methode der Überlappungswichtung, die von Transversalfiltern her bekannt ist, kann hier nicht ohne gravierende Nachteile angewendet werden, weil die Amplituden über die gesamte Apertur der beteiligten Wandler im wesentlichen konstant sein müssen. Bei einer weiteren speziellen Ausführung, die der vorliegenden Erfindung am nachsten kommt, ist dieses Problem durch Lückenwichtung gelöst (H. Yatsuda, IEEE Transactions on Ultrasonics, Ferroelectrics and Frequency Control vol. 41, March 1997, S. 453-459) [2].

Eine andere Art, die von Zinkengruppen erzeugten Wellenamplituden so zu wichten, dass sie über die gesamte Apertur der beteiligten Wandler im wesentlichen konstant sind, ist in DD 208 512 [3] beschrieben. Es handelt sich dort nicht um Einphasen-Unidirektionalwandler, sondern um Wandler, die zusammen mit einem Wandler mit Überlappungswichtung ein Transversalfilter bilden und infolge ihrer Wichtung die Sperrselektion im Vergleich zur Verwendung uniformer Wandler verbessern. Die Zinkengruppen der besagten Wandler sind zueinander parallel und bilden deshalb keine sich verjüngende Struktur. Jede Zinkengruppe ist aus zwei gleich breiten Zinken zusammengesetzt. Die über die gesamte Apertur im wesentlichen homogene, aber trotzdem gewichtete Amplitude wird dadurch gewährleistet, dass einige Zinkengruppen in zwei Subwandler mit gleicher Apertur unterteilt und diese Subwandler elektrisch in Reihe geschaltet sind. Diese so modifizierten Zinkengruppen werden als strukturierte Zinkengruppen bezeichnet. Der Wichtungsfaktor einer in [3] beschriebenen strukturierten Zinkengruppe beträgt ½ im Verhältnis zu einer nicht modifizierten Zinkengruppe. Das ist eine Folge der Reihenschaltung zwei identischer Subwandler einer Zinkengruppe, wodurch die an einer strukturierten Zinkengruppe liegende Spannung ½ der Wandlerspannung beträgt.

Es ist üblich, mit geeigneten Verfahren anhand der Filterspezifikation stetige Wichtungsfunktionen zu bestimmen und diese anschließend in eine Lückenwichtung zu konvertieren. Die Lösung [2] hat den Nachteil, dass in manchen Fällen die Lückenwichtung, die lediglich Wichtungsfaktoren gleich 0 oder ±1 zulässt, zu grob ist, um eine stetige Wichtungsfunktion mit hinreichender Genauigkeit nachbilden zu können. Infolgedessen kann das so implementierte Filter insbesondere im Sperrbereich erheblich von den Forderungen der Filterspezifikation abweichen, obwohl die Anwendung der stetigen Wichtungsfunktion, die hier allerdings lediglich theoretische Bedeutung hat, die Erfüllung der Forderungen gewährleistet hätte.

Eine weitere Art, die von Zinkengruppen erzeugten Wellenamplituden zu wichten, wird in FR-A-2 398 411 beschrieben.

### Darstellung der Erfindung

Der Erfindung liegt die Aufgabe zugrunde, Wandler für akustische Oberflächenwellen der bekannten Art so zu verändern, dass trotz im wesentlichen homogenen Amplitudenprofils auch andere Wichtungsfaktoren als 0 oder ±1 realisiert werden können.

Als Wandler der bekannten Art werden dabei solche betrachtet, die aus auf einem piezoelektrischen Substrat angeordneten Zinkengruppen, die jeweils aus mindestens zwei Zinken bestehen, und Sammelelektroden zusammengesetzt sind, wobei die gesamte Zinkenanordnung eine sich in Richtung einer der Sammelelektroden verjüngende Struktur bildet.

Die Aufgabe ist mit dem im Patentanspruch 1 beschriebenen Wandler für akustische Oberflächenwellenfilter gelöst. Die Unteransprüche geben Ausführungsarten der Erfindung an:

Zur Lösung der Aufgabe sind einige der Zinkengruppen, bezeichnet als strukturierte Zinkengruppen, in Zinkenrichtung in eine Anzahl von Subwandlern unterteilt und elektrisch in Reihe geschaltet sind, wodurch sie sich von den übrigen Zinkengruppen hinsichtlich der von ihnen angeregten Wellenamplitude unterscheiden.

Diese Lösung gestattet es, die Vorteile der sich verjüngenden Wandlerstrukturen mit der Anwendung unstetiger Wichtungsverfahren zu kombinieren, die feiner abgestufte Wichtungsfaktoren als die Lückenwichtung erlauben. Wenn eine strukturierte Zinkengruppe in N identische, elektrisch in Reihe geschaltete Subwandler unterteilt ist, so ist der Wichtungsfaktor dieser Zinkengruppe gleich ±1/N. Neben den für die Lückenwichtung charakteristischen Wichtungsfaktoren O^{•} und ±1 sind demzufolge weitere Wichtungsfaktoren, z. B. ±1/2 und ±1/3, einstellbar.

Das beschriebene Wichtungsverfahren, das mit der verjüngten Ausrichtung der Wandlerzinken kombiniert ist, hat für Wandler ohne verjüngte Zinkenausrichtung eine geringe Bedeutung, weil in diesem Fall die Überlappungswichtung zur Verfügung steht, die auch gewöhnlich angewendet wird. Im Gegensatz dazu ist die Anwendung der Überlappungswichtung bei verjüngter Zinkenausrichtung nicht sinnvoll, weil diese deren Vorteile zunichte machen würde. Deshalb sind nur solche Wichtungsverfahren anwendbar, welche die elektrische Spannung an den Zinken modifizieren. Das beschriebene Wichtungsverfahren ist in der Lage, das zu bewirken. Obwohl für Wandler ohne verjüngte Zinkenausrichtung von geringer Bedeutung, bietet die beanspruchte Merkmalekombination in überraschender Weise eine verbesserte Lösung des Wichtungsproblems bei Wandlern mit verjüngter Zinkenausrichtung.

Die Erfindung kann wie folgt zweckmäßig ausgestaltet sein.

Gemäß einer ersten zweckmäßigen Ausgestaltung haben alle Subwandler die gleiche Apertur.

Außerdem ist es zweckmäßig, wenn alle Zinkengruppen zwei oder drei Zinken enthalten.

Besonders zweckmäßig ist es, wenn jeweils zwei Zinken einer strukturierten Zinkengruppe ein Zinkenpaar bilden, wobei die Zinken eines Zinkenpaares gleich breit und an verschiedene Sammelelektroden angeschlossen sind sowie so zueinander angeordnet sind, dass das Zinkenpaar insgesamt reflexionslos ist und die jeweils dritte Zinke eine Reflektorzinke ist. Spezielle Ausführungen davon sind, dass die Zinkengruppen als EWC- oder DART-Zellen ausgebildet sind.

Wenn die Zinkengruppen aus zwei Zinken bestehen, kann in den strukturierten Zinkengruppen eine Zinke eines Subwandlers mit der jeweils anderen Zinke des folgenden Subwandlers oder mit der gleichen Zinke des folgenden Subwandlers elektrisch leitend verbunden sein.

Wenn die Zinkengruppen aus einem Zinkenpaar und einer Reflektorzinke bestehen, so können in jedem Subwandler der strukturierten Zinkengruppen die Reflektorzinke und eine Zinke des Zinkenpaares elektrisch leitend zu einer Zinkenuntergruppe verbunden sein.

Weiterhin ist es zweckmäßig, wenn jede Zinkenuntergruppe mit derjenigen Zinke des folgenden Subwandlers derselben Zinkengruppe elektrisch leitend verbunden ist, die nicht zu einer Zinkenuntergruppe gehört. Es ist aber auch möglich, dass wenigstens eine Zinkenuntergruppe mit der Zinkenuntergruppe des folgenden Subwandlers derselben Zinkengruppe elektrisch leitend verbunden ist.

Die Approximation der Wichtung an die stetige Funktion zur Amplituden- bzw. Reflexionsfaktorwichtung kann unterstützt werden, wenn sich die Breiten der zum jeweiligen Zinkenpaar gehörenden Zinken bzw. sich die Breite der Reflektorzinke in wenigstens einer Zinkengruppe von denen in den übrigen Zinkengruppen unterscheiden bzw. unterscheidet.

Es ist zweckmäßig, wenn strukturierte Zinkengruppen mit unterschiedlicher Anzahl von Subwandlern mit jeweils gleicher Apertur vorhanden sind. Andererseits können alle strukturierten Zinkengruppen auch in die gleiche Anzahl von Subwandlern mit jeweils gleicher Apertur unterteilt sein.

Besagter Wandler kann aber auch wenigstens zwei benachbarte Zinkengruppen enthalten, deren Anzahl von Subwandlern mit gleicher Apertur gleich ist. In diesem Fall ist es zweckmäßig, die Zinkenuntergruppen der benachbarten Zinkengruppen elektrisch leitend miteinander zu verbinden.

Schließlich ist es überaus zweckmäßig, wenn ein erfindungsgemäßer Wandler der Eingangs- und/oder Ausgangswandler eines akustischen Oberflächenwellenfilters ist.

Die Erfindung ist nachstehend anhand eines Ausführungsbeispiels und einer zugehörigen Zeichnung näher erläutert.

### Kurze Beschreibung der Zeichnungen

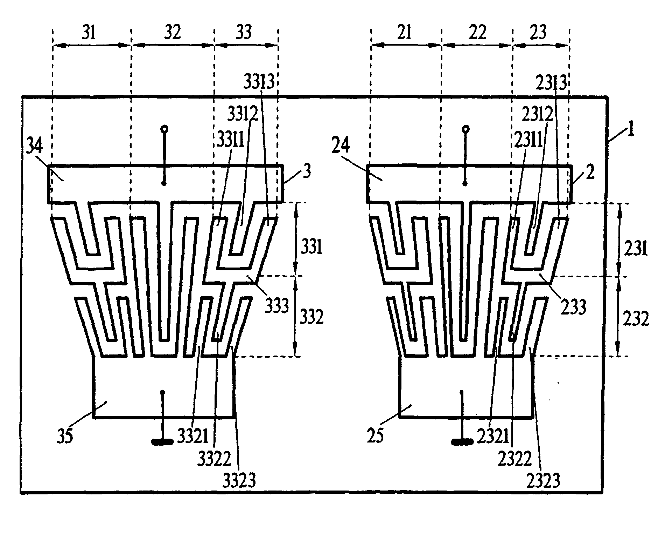

Die Zeichnung zeigt ein akustisches Oberflächenwellenfilter, bei dem auf einem piezoelektrischen Substrat zwei Wandlern für akustische Oberflachenwellen angeordnet sind.

### Bester Weg zur Ausführung der Erfindung

Bei dem in der Zeichnung dargestellten akustischen Oberflächenwellenfilter sind auf einem piezoelektrischen Substrat 1 zwei Wandler 2 und 3 für akustische Oberflächenwellen angeordnet. Der Wandler 2 ist aus den Zinkengruppen 21, 22 und 23 sowie aus den Sammelelektroden 24 und 25 zusammengesetzt. Alle Zinkenkanten sind so gegeneinander geneigt, dass die gesamte Zinkenanordnung eine sich in Richtung der Sammelelektrode 25 verjüngende Struktur bildet. Die Zinkengruppen 21, 22 und 23 sind DART-Zellen. Die Zinkengruppen 21 und 23 sind, von der unterschiedlichen Neigung ihrer Zinken abgesehen, identisch aufgebaut. Deshalb wird lediglich die Zinkengruppe 23 näher beschrieben. Sie ist in die Subwandler mit gleicher Apertur 231 und 232 unterteilt. Der Subwandler 231 bzw. 232 besteht aus den ein Zinkenpaar bildenden Zinken 2311 und 2312 bzw. 2321 und 2322 sowie der Reflektorzinke 2313 bzw. 2323. Dem Aufbau einer DART-Zelle entsprechend, sind die Zinken 2311 und 2312 bzw. 2321 und 2322, die jeweils ein Zinkenpaar bilden, p_{zg}/8 breit und haben einen Abstand ihrer Mittellinien von p_{zg}/4. p_{zg} ist dabei die Länge der Zinkengruppe 22 längs einer Geraden, die parallel zu den Sammelelektroden 24 und 25 in vorgegebenem Abstand von einer dieser Sammelelektroden verläuft. Die Reflektorzinken 2313 und 2323 haben eine Breite von 3p_{zg}/8. Der Abstand der Mittellinie der Zinke 2312 bzw. 2322 von der Mittellinie der jeweiligen Reflektorzinke 2313 bzw. 2323 beträgt 3p_{zg}/8. Im Subwandler 231 sind die Reflektorzinke 2313 und die Zinke 2311 über die elektrisch leitende Verbindung 233 zu einer Zinkenuntergruppe verbunden, wobei die Verbindung 233 gleichzeitig eine Sammelelektrode des Subwandlers 231 ist. Die elektrisch leitende Verbindung der Zinken 2321 und 2323 des Subwandlers 232 ist durch die Sammelelektrode 25 hergestellt. Somit ist die aus den Zinken 2311 und 2313 bestehende Zinkenuntergruppe des Subwandlers 231 mit derjenigen Zinke 2322 des folgenden Subwandlers 232 derselben Zinkengruppe 23 elektrisch leitend verbunden, die nicht zu der aus den Zinken 2321 und 2323 bestehenden Zinkenuntergruppe gehört. Die Subwandler 231 und 232 sind demzufolge elektrisch in Reihe geschaltet. Infolgedessen liegt zwischen der Zinke 2312 und der aus den Zinken 2311 und 2313 gebildeten Zinkenuntergruppe sowie zwischen der Zinke 2322 und der aus den Zinken 2321 und 2323 gebildeten Zinkenuntergruppe eine halb so große Spannung wie zwischen den Sammelektroden 24 und 25, was dazu führt, dass die von den Zinkengruppen 21 und 23 erzeugten Wellenamplituden halb so groß sind wie die von der Zinkengruppe 22 erzeugte Amplitude.

Der Wandler 3 ist aus den Zinkengruppen 31, 32 und 33 sowie aus den Sammelelektroden 34 und 35 zusammengesetzt. Alle Zinkenkanten sind so gegeneinander geneigt, dass die gesamte Zinkenanordnung eine sich in Richtung der Sammelelektrode 35 verjüngende Struktur bildet. Die Zinkengruppen 31 und 33 sind, von der unterschiedlichen Neigung ihrer Zinken abgesehen, identisch aufgebaut. Deshalb wird lediglich die Zinkengruppe 33 näher beschrieben. Sie ist in die Subwandler mit gleicher Apertur 331 und 332 unterteilt. Der Subwandler 331 bzw. 332 besteht aus den Zinken 3311, 3312 und 3313 bzw. 3321, 3322 und 3323. Alle diese Zinken sowie alle Lücken zwischen ihnen sind p_{zg} /6 breit. p_{zg} ist dabei die Länge der Zinkengruppe 32 längs einer Geraden, die parallel zu den Sammelelektroden 34 und 35 in vorgegebenem Abstand von einer dieser Sammelelektroden verläuft. Im Subwandler 331 sind die Zinken 3313 und 3311 über die elektrisch leitende Verbindung 333 zu einer Zinkenuntergruppe verbunden, wobei die Verbindung 333 gleichzeitig eine Sammelelektrode des Subwandlers 331 ist. Die elektrisch leitende Verbindung der Zinken 3321 und 3323 des Subwandlers 332 ist durch die Sammelelektrode 35 hergestellt. Somit ist die aus den Zinken 3311 und 3313 bestehende Zinkenuntergruppe des Subwandlers 331 mit derjenigen Zinke 3322 des folgenden Subwandlers 332 derselben Zinkengruppe 33 elektrisch leitend verbunden, die nicht zu der aus den Zinken 3321 und 3323 bestehenden Zinkenuntergruppe gehört. Die Subwandler 331 und 332 sind demzufolge elektrisch in Reihe geschaltet. Infolgedessen liegt zwischen der Zinke 3312 und der aus den Zinken 3311 und 3313 gebildeten Zinkenuntergruppe sowie zwischen der Zinke 3322 und der aus den Zinken 3321 und 3323 gebildeten Zinkenuntergruppe eine halb so große Spannung wie zwischen den Sammelektroden 34 und 35, was dazu fuhrt, dass die von den Zinkengruppen 31 und 33 erzeugten Wellenamplituden halb so groß sind wie die von der Zinkengruppe 32 erzeugte Amplitude.

Der Wandler 2 wird als Eingangswandler und der Wandler 3 als Ausgangswandler des akustischen Oberflächenwellenfilters betrieben.

## Patentansprüche

1. Wandler für akustische Oberflächenwellen, der aus auf einem piezoelektrischen Substrat (1) angeordneten Zinkengruppen (21-23;31-33), die jeweils aus mindestens zwei Zinken bestehen, und Sammelelektroden (24;25;34;35) zusammengesetzt ist, wobei die gesamte Zinkenanordnung eine sich in Richtung einer der Sammelelektroden verjüngende Struktur bildet, **dadurch gekennzeichnet, dass** einige der Zinkengruppen (21;23;31;33), bezeichnet als strukturierte Zinkengruppen, in Zinkenrichtung in eine Anzahl von Subwandlern (231;232;331;332) unterteilt und elektrisch in Reihe geschaltet sind, wodurch sie sich von den übrigen Zinkengruppen hinsichtlich der von ihnen angeregten Wellenamplitude unterscheiden.

2. Wandler für akustische Oberflächenwellen nach Anspruch 1, **dadurch gekennzeichnet, dass** alle Subwandler (231;232;331;332) die gleiche Apertur haben.

3. Wandler für akustische Oberflächenwellen nach Anspruch 1, **dadurch gekennzeichnet, dass** jede Zinkengruppe zwei Zinken enthält.

4. Wandler für akustische Oberflächenwellen nach Anspruch 1, **dadurch gekennzeichnet, dass** jede Zinkengruppe (21-23;31-33) drei Zinken enthält.

5. Wandler für akustische Oberflächenwellen nach Anspruch 4, **dadurch gekennzeichnet, dass** jeweils zwei Zinken (2311+2312; 2321+2322; 3312+3313; 3322+3323) einer strukturierten Zinkengruppe (23;33) ein Zinkenpaar bilden, wobei die Zinken eines Zinkenpaares gleich breit und an verschiedene Sammelelektroden (24;25;34;35) angeschlossen sind sowie so zueinander angeordnet sind, dass das Zinkenpaar insgesamt reflexionslos ist und die jeweils dritte Zinke (2313;2323;3311;3321) eine Reflektorzinke ist.

6. Wandler für akustische Oberflächenwellen nach Anspruch 5, **dadurch gekennzeichnet, dass** jede Zinkengruppe (21-23;31-33) eine DART-Zelle ist.

7. Wandler für akustische Oberflächenwellen nach Anspruch 5, **dadurch gekennzeichnet, dass** jede Zinkengruppe (21-23;31-33) eine EWC-Zelle ist.

8. Wandler für akustische Oberflächenwellen nach Anspruch 3, **dadurch gekennzeichnet, dass** in den strukturierten Zinkengruppen eine Zinke eines Subwandlers mit der jeweils anderen Zinke des folgenden Subwandlers elektrisch leitend verbunden ist.

9. Wandler für akustische Oberflächenwellen nach Anspruch 3, **dadurch gekennzeichnet, dass** in den strukturierten Zinkengruppen eine Zinke eines Subwandlers mit der gleichen Zinke des folgenden Subwandlers elektrisch leitend verbunden ist.

10. Wandler für akustische Oberflächenwellen nach Anspruch 5, **dadurch gekennzeichnet, dass** in jedem Subwandler (231;232;331;332) der strukturierten Zinkengruppen (231;232;331;332) die Reflektorzinke (2313;2323;3311;3321) und eine Zinke (2311;2321;3313;3323) des Zinkenpaares elektrisch leitend zu einer Zinkenuntergruppe verbunden sind.

11. Wandler für akustische Oberflächenwellen nach Anspruch 10, **dadurch gekennzeichnet, dass** jede Zinkenuntergruppe (2311+2313;3311+3313) mit derjenigen Zinke (2322;3322) des folgenden Subwandlers (232;332) derselben Zinkengruppe (23;33) elektrisch leitend verbunden ist, die nicht zu einer Zinkenuntergruppe gehört.

12. Wandler für akustische Oberflächenwellen nach Anspruch 10, **dadurch gekennzeichnet, dass** wenigstens eine Zinkenuntergruppe mit der Zinkenuntergruppe des folgenden Subwandlers derselben Zinkengruppe elektrisch leitend verbunden ist.

13. Wandler für akustische Oberflächenwellen nach Anspruch 5, **dadurch gekennzeichnet, dass** sich die Breiten der zum jeweiligen Zinkenpaar gehörenden Zinken (2311;2312;2321;2322;3312;3313;3322;3323) in wenigstens einer Zinkengruppe (21-23;31;33) von denen in den übrigen Zinkengruppen unterscheiden.

14. Wandler für akustische Oberflächenwellen nach Anspruch 5, **dadurch gekennzeichnet, dass** sich die Breite der Reflektorzinke (2313;2323;3311;3321) in wenigstens einer Zinkengruppe (21-23;31;33) von denen in den übrigen Zinkengruppen unterscheidet.

15. Wandler für akustische Oberflachenwellen nach Anspruch 2, **dadurch gekennzeichnet, dass** strukturierte Zinkengruppen (21;23;31;33) mit unterschiedlicher Anzahl von Subwandlern (231;232;331;332) mit jeweils gleicher Apertur vorhanden sind.

16. Wandler für akustische Oberflächenwellen nach Anspruch 2, **dadurch gekennzeichnet, dass** alle strukturierten Zinkengruppen (21;23;31;33) in die gleiche Anzahl von Subwandlern (231;232;331;332) mit jeweils gleicher Apertur unterteilt sind.

17. Wandler für akustische Oberflächenwellen nach Anspruch 2, **dadurch gekennzeichnet, dass** dieser wenigstens zwei benachbarte Zinkengruppen enthält, deren Anzahl von Subwandlern mit gleicher Apertur gleich ist.

18. Wandler für akustische Oberflächenwellen nach Anspruch 10 und 17, **dadurch gekennzeichnet, dass** die Zinkenuntergruppen der benachbarten Zinkengruppen elektrisch leitend miteinander verbunden sind.

19. Verwendung eines Wandlers für akustische Oberflächenwellen nach Anspruch 1 als Eingangs- und/oder Ausgangswandler eines akustischen Oberflächenwellenfilters.

## Claims

1. Transducer for surface acoustic waves, which is composed of tine groups (21-23; 31-33) which are arranged on a piezoelectric substrate (1) and are each formed from at least two tines, and collecting electrodes (24; 25; 34; 35), with the entire tine arrangement forming a structure which tapers in the direction of one of the collecting electrodes, **characterized in that** some of the tine groups (21; 23; 31; 33), referred to as structured tine groups, are subdivided in the tine direction into a number of sub-transducers (231; 232; 331; 332) and are electrically connected in series, so that they differ from the other tine groups in terms of the wave amplitude which is stimulated by them.

2. Transducer for surface acoustic waves according to Claim 1, **characterized in that** all the sub-transducers (231; 232; 331; 332) have the same aperture.

3. Transducer for surface acoustic waves according to Claim 1, **characterized in that** each tine group contains two tines.

4. Transducer for surface acoustic waves according to Claim 1, **characterized in that** each tine group (21-23; 31-33) contains three tines.

5. Transducer for surface acoustic waves according to Claim 4, **characterized in that** two tines (2311+2312; 2321+2322; 3312+3313; 3322+3323) in each structured tine group (23; 33) form a tine pair, with the tines of a tine pair being of equal width, being connected to different collecting electrodes (24; 25; 34; 35) and being arranged with respect to one another such that the tine pair produces no reflections overall, and the respective third tine (2313; 2323; 3311; 3321) is a reflector tine.

6. Transducer for surface acoustic waves according to Claim 5, **characterized in that** each tine group (21-23; 31-33) is a DART cell.

7. Transducer for surface acoustic waves according to Claim 5, **characterized in that** each tine group (21-23; 31-33) is a EWC cell.

8. Transducer for surface acoustic waves according to Claim 3, **characterized in that**, in the structured tine groups, one tine of one sub-transducer is electrically conductively connected to the respective other tine of the next sub-transducer.

9. Transducer for surface acoustic waves according to Claim 3, **characterized in that**, in the structured tine groups, one tine of one sub-transducer is electrically conductively connected to the same tine of the next sub-transducer.

10. Transducer for surface acoustic waves according to Claim 5, **characterized in that**, in each sub-transducer (231; 232; 331; 332) of the structured tine groups (21; 23; 31; 33) the reflector tine (2313; 2323; 3311; 3321) and one tine (2311; 2321; 3313; 3323) of the tine pair are electrically conductively connected to form a tine subgroup.

11. Transducer for surface acoustic waves according to Claim 10, **characterized in that** each tine subgroup (2311+2313; 3311+3313) is electrically conductively connected to that tine (2322; 3322) of the next sub-transducer (232; 332) in the same tine group (23; 33) which is not part of a tine subgroup.

12. Transducer for surface acoustic waves according to Claim 10, **characterized in that** at least one tine subgroup is electrically conductively connected to the tine subgroup of the next sub-transducer in the same tine group.

13. Transducer for surface acoustic waves according to Claim 5, **characterized in that** the widths of the tines (2311; 2312; 2321; 2322; 3312; 3313; 3322; 3323) which belong to the respective tine pair in at least one tine group (21-23; 31; 33) are different from those in the other tine groups.

14. Transducer for surface acoustic waves according to Claim 5, **characterized in that** the width of the reflector tine (2313; 2323; 3311; 3321) in at least one tine group (21-23; 31; 33) is different from those in the other tine groups.

15. Transducer for surface acoustic waves according to Claim 2, **characterized in that** structured tine groups (21; 23; 31; 33) with a different number of sub-transducers (231; 232; 331; 332) and each having the same aperture are provided.

16. Transducer for surface acoustic waves according to Claim 2, **characterized in that** all the structured tine groups (21; 23; 31; 33) are subdivided into the same number of sub-transducers (231; 232; 331; 332), each having the same aperture.

17. Transducer for surface acoustic waves according to Claim 2, **characterized in that** this transducer contains at least two adjacent tine groups, whose number of sub-transducers with the same aperture is the same.

18. Transducer for surface acoustic waves according to Claims 10 and 17, **characterized in that** the tine subgroups in the adjacent tine groups are electrically conductively connected to one another.

19. Use of a transducer for surface acoustic waves according to Claim 1 as an input and/or output transducer for a surface acoustic wave filter.

## Revendications

1. Transducteur pour ondes acoustiques de surface, lequel se compose de groupes de pointes (21-23 ; 31-33) disposés sur un substrat piézoélectrique (1), constitués chacun d'au moins deux pointes, et d'électrodes collectrices (24 ; 25 ; 34 ; 35), l'arrangement de pointes complet formant une structure qui s'amincit en direction de l'une des électrodes collectrices, **caractérisé en ce que** certains des groupes de pointes (21 ; 23 ; 31 ; 33), désignés sous le nom de groupes de pointes structurés, sont divisés en un certain nombre de sous-transducteurs (231 ; 232 ; 331 ; 332) dans le sens des pointes et branchés électriquement en série, ce qui les différencie des autres groupes de pointes du point de vue de l'amplitude des ondes qu'ils engendrent.

2. Transducteur pour ondes acoustiques de surface selon la revendication 1, **caractérisé en ce que** tous les sous-transducteurs (231 ; 232 ; 331 ; 332) ont la même ouverture.

3. Transducteur pour ondes acoustiques de surface selon la revendication 1, **caractérisé en ce que** chaque groupe de pointes contient deux pointes.

4. Transducteur pour ondes acoustiques de surface selon la revendication 1, **caractérisé en ce que** chaque groupe de pointes (21-23 ; 31-33) contient trois pointes.

5. Transducteur pour ondes acoustiques de surface selon la revendication 4, **caractérisé en ce que** deux pointes (2311+2312 ; 2321+2322 ; 3312+3313 ; 3322+3323) d'un groupe de pointes structuré (23 ; 33) forment à chaque fois une paire de pointes, les pointes d'une paire de pointes ayant la même largeur et étant raccordées à des électrodes collectrices (24 ; 25 ; 34 ; 35) différentes et étant disposées l'une par rapport à l'autre de sorte que la paire de pointes soit globalement dépourvue de réflexion et que la troisième pointe correspondante (2313 ; 2323 ; 3311 ; 3321) soit une pointe de réflexion.

6. Transducteur pour ondes acoustiques de surface selon la revendication 5, **caractérisé en ce que** chaque groupe de pointes (21-23 ; 31-33) est une cellule DART.

7. Transducteur pour ondes acoustiques de surface selon la revendication 5, **caractérisé en ce que** chaque groupe de pointes (21-23 ; 31-33) est une cellule EWC.

8. Transducteur pour ondes acoustiques de surface selon la revendication 3, **caractérisé en ce que** dans les groupes de pointes structurés, une pointe d'un sous-transducteur est reliée électriquement à l'autre pointe correspondante du sous-transducteur suivant.

9. Transducteur pour ondes acoustiques de surface selon la revendication 3, **caractérisé en ce que** dans les groupes de pointes structurés, une pointe d'un sous-transducteur est reliée électriquement à la même pointe du sous-transducteur suivant.

10. Transducteur pour ondes acoustiques de surface selon la revendication 5, **caractérisé en ce que** dans chaque sous-transducteur (231 ; 232 ; 331 ; 332) des groupes de pointes structurés(21 ; 23 ; 31 ; 33), la pointe de réflexion (2313 ; 2323 ; 3311 ; 3321) et une pointe (2311 ; 2321 ; 3313 ; 3323) de la paire de pointes sont reliées électriquement en un sous-groupe de pointes.

11. Transducteur pour ondes acoustiques de surface selon la revendication 10, **caractérisé en ce que** chaque sous-groupe de pointes (2311+2313 ; 3311+3313) est relié électriquement à la pointe (2322 ; 3322) du sous-transducteur (232 ; 332) suivant du même groupe de pointes (23 ; 33) qui ne fait pas partie d'un sous-groupe de pointes.

12. Transducteur pour ondes acoustiques de surface selon la revendication 10, **caractérisé en ce qu'**au moins un sous-groupe de pointes est relié électriquement au sous-groupe de pointes du sous-transducteur suivant du même groupe de pointes.

13. Transducteur pour ondes acoustiques de surface selon la revendication 5, **caractérisé en ce que** les largeurs des pointes (2311 ; 2312 ; 2321 ; 2322 ; 3312 ; 3313 ; 3322 ; 3323) faisant partie de la paire de pointes correspondante se différencient dans au moins un groupe de pointes (21-23 ; 31 ; 33) de celles dans les autres groupes de pointes.

14. Transducteur pour ondes acoustiques de surface selon la revendication 5, **caractérisé en ce que** la largeur de la pointe de réflexion (2313 ; 2323 ; 3311 ; 3321) se différencie dans au moins un groupe de pointes (21-23 ; 31 ; 33) de celles dans les autres groupes de pointes.

15. Transducteur pour ondes acoustiques de surface selon la revendication 2, **caractérisé en ce qu'**il existe des groupes de pointes structurés (21 ; 23 ; 31 ; 33) avec un nombre différent de sous-transducteurs (231 ; 232 ; 331 ; 332) ayant à chaque fois la même ouverture.

16. Transducteur pour ondes acoustiques de surface selon la revendication 2, **caractérisé en ce que** tous les groupes de pointes structurés (21 ; 23 ; 31 ; 33) sont divisés en le même nombre de sous-transducteurs (231 ; 232 ; 331 ; 332) ayant à chaque fois la même ouverture.

17. Transducteur pour ondes acoustiques de surface selon la revendication 2, **caractérisé en ce que** celui-ci comprend au moins deux groupes de pointes voisins dont le nombre de sous-transducteurs ayant la même ouverture est égal.

18. Transducteur pour ondes acoustiques de surface selon la revendication 10 et 17, **caractérisé en ce que** les sous-groupes de pointes des groupes de pointes voisins sont reliés électriquement entre eux.

19. Utilisation d'un transducteur pour ondes acoustiques de surface selon la revendication 1 en tant que transducteur d'entrée et/ou de sortie d'un filtre à ondes acoustiques de surface.
